# EUROPEAN PATENT APPLICATION

(11) **EP 0 697 805 A1**
(43) Date of publication of application: **21.02.1996**
(21) Application number: 95111433.9
(22) Date of filing: 20.07.1995
(51) Int. Cl.: H05K 3/24, H05K 1/09

(54) **Printed circuit board manufacture utilizing electroless palladium**

(30) Priority: 05.08.1994 US 286726
(71) Applicant: LeaRonal, Inc., Freeport, N.Y. 11520 (US)
(72) Inventor: Toben, Michael P., Smithtown, NY 11787 (US); Kanzler, Miriana, Bay Shore, NY 11706 (US); Martin, James L., Merrick, NY 11566 (US); Brasch, William R., Nesconset, NY 11767 (US); O'Brien, Gerard A., Bay Shore, NY 11706 (US)
(74) Representative: Hansen, Bernd, Dr. Dipl.-Chem.

(57) **Abstract**

This invention relates to a new way of manufacturing printed circuit boards by providing a circuit board with a circuit pattern, holes and lands of copper; covering the circuit pattern with a soldermask; and contacting the board with an electroless palladium solution for a sufficient time to provide a final finish layer of palladium at a sufficient thickness to protect the copper deposits in the holes and on the lands from oxide formation and being relatively smooth and flat to provide good solderability and good wire bonding capabilities. The copper circuit pattern, holes and lands is generally provided by plating copper onto the board. Then, the palladium layer may be provided directly onto the copper or onto a layer of electroless nickel which is initially deposited upon the copper.

## Description

### Technical Field

The present invention relates to a method for making a printed circuit board wherein palladium is deposited electrolessly onto the boards or an intermediate layer of electroless nickel to provide a plated substantially flat surface having good solderability and wire bonding properties.

### Background Art

Electronic component manufacturers are constantly looking for improved and less expensive methods for fabricating Printed Circuit Boards ("PCBs"). One such method that has gained much success is referred to as surface mount technology ("SMT"). SMT involves the attachment of components directly to board surfaces via bonding pads, which allows for greater miniaturization and reduced costs by providing increased component density.

As PCB design evolves, many of today's printed circuit boards comprise both SMT and standard through-hole features. This "mixed technology" necessitates the need for good solderability of the surface mount components on the PCB surface, as well as good solderability of leaded components in the through-hole. Surface mount component attachment is achieved by first applying a solder paste to the significant pads of the PCB, placing the surface mount components onto these pads and heating the PCB to melt the solder and both mechanically and electrically secure the components to the board.

In order to have a successful soldering operation, the surfaces of the circuit pads and holes contained in the PCB must be highly solderable. The pads of the boards for component attachment must have a generally flat surface and the solderability of all surfaces prior to assembly should be maintained during prolonged storage.

In addition, miniaturization techniques involving on-board assembly of components by direct chip attachment followed by wire bonding requires the ideal finish to be both solderable and wire bondable.

One of the most prevalent methods of preparing a circuit board for SMT is the hot air solder leveling method. With this method, solder is first applied by immersing the board into molten solder, removing the board with a layer of solder thereon, and then blowing off excess solder by means of hot air. The metal finish produced on PCBs by this method provides good solderability to the board surfaces; however, the resultant surface on the pads is not sufficiently flat for reliable component attachment. Furthermore, the thickness of metal coating obtained at the entrance to the holes is in many cases too low to prevent intermetallic copper-tin compounds from adversely affecting final solderability. Soldering of components to the boards must therefore be completed relatively quickly after the hot air solder leveling method is used. This is often difficult to do since the components to be soldered to the boards are often added by someone other than the board manufacturer.

An alternative method utilizes electrodeposited tin-lead which is subsequently fused after plating. However, PCBs produced by this method also suffer from the same problems seen with hot air solder levelling.

Instead of using fused tin-lead solder for through-hole plated boards, an electroplated coating of tin-lead which is sufficiently thick to prevent significant penetration of intermetallic compounds with the plated layer can be applied and used in the non-fused condition. Unfortunately, non-fused tin-lead is intrinsically less solderable than fused tin-lead and also, the coating beneath the soldermask often melts during the wave-soldering operation, thus adversely affecting the adhesion of the soldermask. In addition, tin-lead coatings are generally not wire bondable.

Other finishes that have been considered for SMT as a replacement for hot air solder leveling include organic coatings, typically triazole derivatives. These materials react with the copper surface of the PCB to form a very thin protective layer. While organic coatings are inexpensive to apply, their ability to provide long-term retention of solderability to copper is relatively poor. In addition, wire-bonding to these materials is not possible.

Electroless deposition of tin-lead would be an attractive alternative, and although certain electroless tin and tin-lead processes have been proposed in the past, they have not thus far found widespread commercial acceptance because they are both expensive and difficult to operate. To date no completely successful electroless tin or tin-lead process has been found and the limitations as to tin-lead deposits would still apply.

The use of a relatively thick (i.e., 2.5 micron) non-porous electroless gold coating could also be considered, since it is highly corrosion resistant and flat, but the reliability of the solder joint is relatively poor due to the formation of brittle gold-tin intermetallic compounds. In addition, the cost of this coating is extremely high such that it is not economically viable.

More recently, a system has been introduced which is designed to meet the criteria for both flatness and long term solderability. This system uses a thin immersion gold coating deposited over an electroless nickel-phosphorous alloy coating (Ni-8%P). The electroless nickel coating (approximately 55 microns) is highly corrosion resistant and prevents diffusion of copper from the substrate. The thin gold coating (less than 0.1 micron) prevents oxidation of the nickel coating and thereby enhances solderability.

The electroless nickel/immersion gold system does not allow for wire bonding with gold wire, however, due to the fact that the immersion gold layer is not sufficiently thick to provide the necessary bond strength. Immersion gold processes work by a displacement mechanism and are therefore self-limiting with respect to maximum achievable thickness. Although electroless gold processes, which provide higher thicknesses, may be considered for gold wire bonding applications, these processes usually are very alkaline and contain free cyanide. Thus, they cannot be used after the application of a soldermask because of their aggressiveness towards the soldermask. Also, if they are used prior to the application of soldermask, a much greater area would be plated thereby greatly increasing the cost of an already expensive process. Moreover, if solderability as well as wire bonding were a requirement, the higher thickness of gold would result in brittle solder joints for the reasons mentioned above.

### Summary of the Invention

The present invention relates to a method for manufacturing printed circuit boards by providing a circuit board having a circuit pattern, holes and lands of copper, covering the circuit pattern with a soldermask, and contacting the board with an electroless palladium solution for a sufficient time to provide a final finish layer of palladium or a palladium alloy at a sufficient thickness to protect the copper deposits in the holes and on the lands from oxide formation and being relatively smooth and flat to provide good solderability or good wire bonding capabilities. The circuit pattern, holes and lands may be provided by plating copper onto the board, preferably by an electroplating process.

In one embodiment, the palladium is deposited directly onto the exposed copper surfaces of the holes and lands of the board at a thickness of between about 0.025 to 2.5µm and preferably about 0.1 to 1µm. Alternatively, a layer of electroless nickel can initially be deposited onto the exposed copper surfaces of the holes and lands on the board with the palladium then deposited upon the nickel deposit. In this embodiment, the nickel may be deposited at a thickness of between about 0.5 and 10µm and preferably about 0.5 and 5µm.

The electroless palladium is plated onto the copper holes and lands of the boards without detrimentally affecting the soldermask. This is important in retaining circuit definition on the boards. Also, the palladium may be deposited at a thickness sufficient to prevent diffusion of copper therethrough. Thus, a wire can be bonded to the circuit board hole to obtain a pull force of at least about 5 grams both initially and after aging for 1 hour at 175°F.

### Detailed Description of the Invention

The method of the present invention produces PCBs having a relatively flat surface, good solderability on the surface pads and in the through-holes, and the capability of being wire bonded with gold or aluminum wire. As noted above, this method is based on the application of an electroless, autocatalytic palladium coating, which is applied either directly to the copper surfaces of the PCB or onto an intermediate layer of electroless nickel.

Electroless palladium plating solutions are readily available in the art and most of them are suitable for use in this invention. Examples of such solutions are described in The Metal Finishing Guidebook, which describes immersion palladium, and are further described in U.S. Patents 5,292,361, 4,424,241, 4,341,846, 4,279,951 and 4,255,194, the content of each of which is expressly incorporated herein by reference thereto. These patents describe methods and solutions for depositing palladium and palladium alloys by electroless methods, but none of them disclose methods for manufacturing PCBs or the use of electroless palladium in the manufacture of such boards.

The PCBs which are to be subjected to electroless palladium plating already have a circuit pattern formed on one or both surfaces of the board and generally include a number of through holes as well. The boards may be simply immersed into the desired electroless palladium plating solution for a sufficient time to preferably deposit at least about 0.2 to 0.5 microns of palladium. Thus, thicknesses greater than 0.1 micron, which are required for gold wire bond applications, can be obtained easily. These deposits are relatively smooth and have good solderability as well as good wire bonding capabilities. The wires can be successfully bonded with either thermosonic or ultrasonic techniques.

The process is cost effective in that the metal cost of palladium is about one third that of gold. In addition, the density of the palladium coating is significantly less than gold, so at the same thickness, there is substantially less weight of palladium relative to gold, making the price of the palladium deposit much more economically attractive.

Another advantage of this process is that the copper from the circuit patterns will not diffuse easily through palladium, so that the application of palladium directly over the copper presents no difficulties. In the case of gold, a nickel barrier layer must be applied to prevent the diffusion of copper into the gold layer. Besides the cost benefit in eliminating the electroless nickel processing step, copper inherently solders better than the Ni-P alloys of the electroless nickel step. Provided that the palladium is sufficiently thick to protect the copper from oxide formation and, at the same time, sufficiently thin (i.e., approximately 0.1-0.2 microns) so as to fully dissolve in the solder during waveform soldering, the copper/palladium coating will provide better solderability than a Ni-P/immersion gold or Ni-P/palladium coating. Since palladium forms intermetallics with tin much more slowly than gold, more reliable solder joints are achieved using this metal.

A further advantage of the electroless palladium process is that the chemical makeup and operating conditions of the process will not attack the typical soldermask materials that are used in PCB manufacture.

Soldermask is a permanent coating applied towards the end of the PCB manufacturing process, after the circuitry has been imaged, developed and electroplated with acid copper. After soldermask is applied, only those areas of the PCB that will be subsequently involved in soldering or bonding operations are exposed. This primarily consists of the plated through holes for leaded component attachment by wave soldering and surface lands for surface mount component attachment through the application of a solder paste. Soldermask protects certain circuitry from becoming soldered during the wave soldering operation. If all the circuitry were exposed to the molten solder wave, the fine copper traces in close proximity to one another would become soldered together, causing bridging between the circuits and rendering the PCB completely useless.

Immediately after soldermask is applied, the PCB's are cut and routed, no longer providing a continuous pathway for electric current to pass. This is why electroless processes, rather than electrolytic processes are required at this stage of manufacture. It is necessary for the electroless or electroplating solutions to not detrimentally affect or remove this soldermask, or the circuit patterns will not be properly defined. The present electroless palladium solutions are fully acceptable in this regard, since the soldermask is relatively unaffected when contacted by these solutions.

In certain situations, the copper circuit patterns can be first provided with an electroless nickel deposit prior to the application of the electroless palladium deposit. The nickel provides an excellent corrosion resistant barrier to the underlying copper, while the top layer of the palladium metal provides a substantially flat deposit having better solderability than the nickel deposit. In this arrangement, the nickel deposit should preferably be between about 2 and 4 microns, with the palladium layer preferably having a thickness of being between about 0.1 and 0.5 microns.

Electroless nickel processes are well known in the art. Typical processes are disclosed in D. Crotty, "Electroless Nickel Bath Types, Chemistry and Uses"; Proceedings of EN Conference 93; November 10-12, 1993 and G. Mallory, "The Electroless Nickel Plating Bath"; Proceedings of the Electroless Nickel Conference; November 6-7, 1979, the content of each of which is expressly incorporated herein by reference thereto.

### EXAMPLES

The scope of the invention is further described in connection with the following examples which are set forth for purposes of illustration of certain preferred processes of the present invention and which are not to be construed as limiting the overall scope of the invention in any manner.

The substrate used for all tests was a copper clad laminate, type FR-4, which is a composite of epoxy and glass fiber that is commonly used in the PCB industry. Prior to testing, the PCB's are first electroplated with acid copper and provided with a soldermask utilizing techniques which are generally known in the art.

### Example 1

The following process sequence was applied to a PCB having exposed copper at the hole pads and surface lands after soldermask application.
1. Clean the PCB by immersing into an acidic cleaning solution typical of that used in industry for 3 minutes at a temperature of 40°C.
2. Rinse thoroughly with deionized water at ambient temperature.
3. Microetch the exposed copper with an acidic solution of sodium persulfate for 1 minute at 35°C
4. Rinse thoroughly with deionized water at ambient temperature.
5. Immerse the PCB into a solution of 20% v/v hydrochloric acid for 1 minute at ambient temperature.
6. Activate the copper surface by immersing the PCB into an acidic palladium chloride solution containing 100 ppm palladium for 1 minute at ambient temperature.
7. Rinse thoroughly with deionized water at ambient temperature.
8. Deposit electroless nickel from a solution containing nickel ions, nickel complexing agents and sodium hypophosphite as the reducing agent for 20 - 25 minutes at a temperature of 85°C to achieve a total nickel-phosphorous alloy coating of about 3µm.
9. Thoroughly rinse with deionized water at ambient temperature.
10. Deposit electroless palladium from a solution containing palladium ions, palladium complexing agents and sodium hypophosphite as the reducing agent for 6 - 8 minutes at a temperature of 60°C to obtain a palladium-phosphorous alloy coating of about 0.5µm.
11. Thoroughly rinse with deionized water at 60°C.
12. Dry.

The resultant deposits were bright and uniform. Solderability testing performed by a wetting balance method exhibited an average wetting force of 200 µN/mm at 2 seconds over a wide variety of accelerated aging conditions.

### Example 2 (Comparative)

The following process sequence was applied to the same starting PCB which was used in Example 1 after soldermask application.
1. Clean the PCB by immersing into an acidic cleaning solution typical of that used in industry for 3 minutes at a temperature of 40°C.
2. Rinse thoroughly with deionized water at ambient temperature.
3. Microetch the exposed copper with an acidic solution of sodium persulfate for 1 minute at 35°C.
4. Rinse thoroughly with deionized water at ambient temperature.
5. Immerse the PCB into a solution of 20% v/v hydrochloric acid for 1 minute at ambient temperature.
6. Activate the copper surface by immersing the PCB into an acidic palladium chloride solution containing 100 ppm palladium for 1 minute at ambient temperature.
7. Rinse thoroughly with deionized water at ambient temperature.
8. Deposit electroless nickel from a solution containing nickel ions, nickel complexing agents and sodium hypophosphite as the reducing agent for 20 - 25 minutes at a temperature of 85°C to achieve a total nickel-phosphorous alloy coating of about 3µm.
9. Thoroughly rinse with deionized water at ambient temperature.
10. Deposit immersion gold from a solution containing potassium gold cyanide and organic carboxylic acids for 15 minutes at a temperature of about 85°C to achieve a total gold thickness of about 0.1µm).
11. Thoroughly rinse with deionized water at 60°C.
12. Dry.

The resultant deposits were bright and uniform. Solderability testing performed by a wetting balance method exhibited an average wetting force of 200 µN/mm at 2 seconds over a wide variety of accelerated aging conditions. However, the overall cost for this process was about 20% greater than for that of Example 1 due to the increased cost of the gold metal in the process.

### Example 3

The following process sequence was applied to the same starting PCB which was used in Example 1 after soldermask application.
1. Clean the PCB by immersing into an acidic cleaning solution typical of that used in industry for 3 minutes at a temperature of 40°C.
2. Rinse thoroughly with deionized water at ambient temperature.
3. Microetch the exposed copper with an acidic solution of sodium persulfate for 1 minute at 35°C.
4. Rinse thoroughly with deionized water at ambient temperature.
5. Immerse the PCB into a solution of 20% v/v hydrochloric acid for 1 minute at ambient temperature.
6. Activate the copper surface by immersing the PCB into an acidic palladium chloride solution containing 100 ppm palladium for 1 minute at ambient temperature.
7. Rinse thoroughly with deionized water at ambient temperature.
8. Deposit electroless palladium from a solution containing palladium ions, palladium complexing agents and sodium hypophosphite as the reducing agent for 3 - 4 minutes at a temperature of 60°C to obtain a palladium-phosphorous alloy coating of about 0.15µm.
9. Thoroughly rinse with deionised water at 60°C.
10. Dry.

The resultant deposits were semi-bright and uniform. Solderability testing was performed by wave soldering and evaluating the percentage area wetted with solder. The panels exhibited good solderability over a variety of accelerated aging conditions.

### Example 4 (Comparative)

The following process sequence was applied to the same starting PCB which was used in Example 1 after soldermask application.
1. Clean the PCB by immersing into an acidic cleaning solution typical of that used in industry for 3 minutes at a temperature of 40°C.
2. Rinse thoroughly with deionized water at ambient temperature.
3. Microetch the exposed copper with an acidic solution of sodium persulfate for 1 minute at 35°C.
4. Rinse thoroughly with deionized water at ambient temperature.
5. Immerse the PCB into a solution of 20% v/v hydrochloric acid for 1 minute at ambient temperature.
6. Activate the copper surface by immersing the PCB into an acidic palladium chloride solution containing 100 ppm palladium for 1 minute at ambient temperature.
7. Rinse thoroughly with deionized water at ambient temperature.
8. Deposit electroless nickel from a solution containing nickel ions, nickel complexing agents and sodium hypophosphite as the reducing agent for 20-25 minutes at a temperature of 85°C to obtain a total nickel-phosphorous alloy coating of about 3µm.
9. Thoroughly rinse with deionized water at ambient temperature.
10. Deposit immersion gold from a solution containing potassium gold cyanide and organic carboxylic acids for 15 minutes at a temperature of 85°C to obtain a gold thickness of about 0.1µm.
11. Thoroughly rinse with deionized water at 60°C.
12. Dry.

The resultant deposits were bright and uniform. Solderability testing was performed by wave soldering and evaluating the percentage area wetted with solder. The panels exhibited good solderability over a variety of accelerated aging conditions. However, the overall cost for this process was about 500% greater than for that of Example 3 due to the increased cost of the gold metal and the use of the electroless nickel.

### Example 5

Wire bonding tests were conducted on a number of different electroless deposits using a gold wire of 1 mil diameter and an ultrasonic method. As noted above, the substrate was a conventional copper plated FR-4 laminate which is widely used in the printed circuit board industry. The results are illustrated in Table 1 below:

**Table 1**

| Deposit | **GRAM PULL FORCE** | |
|---|---|---|
| | As Plated | After 1 Hr @ 175°F |
| Electroless Ni/P (3.0µm) | 6-15 | 7-11 |
| Electroless Pd (0.5µm) | | |
| Electroless Ni/P (3.0µm) | 5-10 | 5-10 |
| Electroless Pd (0.15µm) | | |
| Electroless Ni/P (3.0µm) | 5-12 | 0-12 |
| Electroless Au (0.15µm) (Comparative) | | |
| Electroless Pd (0.5µm) | 8-13 | 5-13 |
| Electroless Pd (0.15µm) | 5-10 | 0-10 |

The results show that an electroless palladium deposit having a thickness of about 0.5µm on the copper circuits or an electroless palladium deposit having a thickness of about 0.15µm over an electroless nickel deposit provides good bonding to gold wire both initially and after aging at 175°F for 1 hour.

While there has been shown and described what are considered to be preferred embodiments of the invention, it will of course be understood that various modifications and changes in form or detail could readily be made without departing from the spirit of the invention. It is therefore intended that the invention be not limited to the exact form and detail herein shown and described, nor to anything less than the whole of the invention herein disclosed as hereinafter claimed.

## Claims

1. A method for manufacturing printed circuit boards which comprises:
providing a circuit board with a circuit pattern, holes and lands of copper;
covering the circuit pattern with a soldermask; and
contacting the board with an electroless palladium solution for a sufficient time to provide a final finish layer of palladium or a palladium alloy at a sufficient thickness to protect the copper deposits in the holes and on the lands from oxide formation and being relatively smooth and flat to provide good solderability.

2. A method for manufacturing printed circuit boards which comprises:
providing a circuit board with a circuit pattern, holes and lands of copper;
covering the circuit pattern with a soldermask; and
contacting the board with an electroless palladium solution for a sufficient time to provide a final finish layer of palladium or a palladium alloy at a sufficient thickness to protect the copper deposits in the holes and on the lands from oxide formation and being relatively smooth and flat to provide good wire bonding capabilities.

3. The method of claim 1 or 2 which further comprises providing the circuit pattern, holes and lands by electroplating copper onto the board.

4. The method of claim 1 or 2 which further comprises depositing the palladium directly onto the exposed copper surfaces of the holes and lands of the board.

5. The method of claim 1 or 2 which further comprises depositing the palladium to a thickness of between about 0.025 to 2.5µm.

6. The method of claim 1 or 2 which further comprises depositing the palladium to a thickness of between about 0.1 to 1µm.

7. The method of claim 1 or 2 which further comprises depositing a layer of electroless nickel onto the exposed copper surfaces of the holes and lands of the board and then depositing the palladium upon the nickel deposit.

8. The method of claim 7 which further comprises depositing the electroless nickel layer to a thickness of between about 0.5 and 10µm and then depositing the palladium upon the nickel layer.

9. The method of claim 7 which further comprises depositing the electroless nickel layer to a thickness of between about 0.5 and 5µm and then depositing the palladium upon the nickel layer.

10. The method of claim 8 or 9 which further comprises depositing the palladium at a thickness of about 0.025 to 2.5µm.

11. The method of claim 8 or 9 which further comprises depositing the palladium at a thickness of about 0.1 to 1µm.

12. The method of claim 1 or 2 wherein the electroless palladium is deposited onto the copper deposits without detrimentally affecting the soldermask.

13. The method of claim 12 which further comprises depositing the palladium at a thickness sufficient to prevent diffusion of copper therethrough.

14. The method of any of the preceding claims which further comprises bonding a wire to a circuit board land to obtain a pull force of at least about 5 grams both initially and after aging for 1 hour at 175°F.
